# EUROPEAN PATENT SPECIFICATION

(11) **EP 3 222 689 B1**
(45) Date of publication and mention of the grant of the patent: **28.11.2018**
(21) Application number: 17160514.0
(22) Date of filing: 13.03.2017
(51) Int. Cl.: C09D 183/06, C08G 77/20, C08L 83/06, H01L 23/00, H01L 51/00, C08G 77/00, C09D 183/10, C08G 77/42, C08L 83/10

(54) **UV CURABLE SILICONE COMPOSITION, CURED PRODUCT THEREOF, OPTICAL ELEMENT ENCAPSULATION MATERIAL COMPRISED OF THE COMPOSITION, AND OPTICAL ELEMENT ENCAPSULATED BY THE ENCAPSULATION MATERIAL**
UV-HÄRTBARE SILIKONZUSAMMENSETZUNG, GEHÄRTETES PRODUKT DARAUS, VERKAPSELUNGSMATERIAL FÜR OPTISCHES ELEMENT MIT DER ZUSAMMENSETZUNG UND DURCH DAS VERKAPSELUNGSMATERIAL VERKAPSELTES OPTISCHES ELEMENT
COMPOSITION DE SILICONE DURCISSABLE AUX UV, SON PRODUIT DURCI, MATÉRIAU D'ENCAPSULATION D'UN ÉLÉMENT OPTIQUE CONSTITUÉ DE LA COMPOSITION ET ÉLÉMENT OPTIQUE ENCAPSULÉ PAR LE MATÉRIAU D'ENCAPSULATION

(30) Priority: 22.03.2016 JP 2016057147
(43) Date of publication of application: 27.09.2017
(73) Proprietor: Shin-Etsu Chemical Co., Ltd., Chiyoda-ku, Tokyo 100-0004 (JP)
(72) Inventor: MATSUMOTO, Nobuaki, Annaka-shi, Gunma 379-0224 (JP); YAGINUMA, Atsushi, Annaka-shi, Gunma 379-0224 (JP); OZAI, Toshiyuki, Annaka-shi, Gunma 379-0224 (JP); KIMURA, Shinji, Annaka-shi, Gunma 379-0224 (JP); KITAGAWA, Taichi, Annaka-shi, Gunma 379-0224 (JP)
(74) Representative: Zacco GmbH

(56) References cited:
- EP-A1- 2 924 085
- EP-A1- 2 995 650
- US-A1- 2007 112 090

## Description

### [Technical field]

The present invention relates to a UV curable silicone composition, a cured product thereof, an optical element encapsulation material comprised of such composition, and an optical element encapsulated by such optical element encapsulation material.

### [Background art]

Silicone rubbers for use in optical element encapsulation materials are required to have a high transparency, a high hardness and a high refractive index. And, there have already been proposed several methods employing, as the main skeleton, a dimethylsiloxane·diphenylsiloxane copolymer or polymethylphenylsiloxane (Patent documents 1 to 5).

Patent EP-A-2 924 085 describes UV curable silicone compositions showing high resistance to plasma comprising a photocurable monomer, a silicone-containing monomer and a photoinitiator for the curing of the composition under UV radiation and used for the encapsulation of organic light-emitting diode display. The photocurable monomer is a monofunctional acrylate compound and/or a multifunctional acrylate compound and the silicone-containing monomer is an organopolysiloxane compound end-capped with acrylate groups.

Patent EP-A-2 995 650 relates to UV curable silicone compositions showing good curability and good resistance to oxygen inhibition comprising (A) a polyorganosiloxane modified with methacrylate end groups, (B) a second polyorganosiloxane modified with acrylate end groups and a photoinitiator.

Patent US-A-2007/0112090 is directed to radiation-curable silicone rubber compositions having good corrosion prevention properties comprising an organopolysiloxane end-capped with a silicon-containing groups that each contain two (meth)acryloyl groups and a radiation sensitizer. The cured compositions are used as a protective coating or sealing agent for electronical devices.

However, the methods that have been proposed so far utilize hydrosilylation reaction, thus making a heating step essential in terms of performing curing. In recent years, energy and time saving in a production process have been demanded more than ever, and a solution to such problem has been strongly desired.

### [Prior art document]

### [Patent document]

[Patent document 1] Japanese Patent No. 4180474
[Patent document 2] Japanese Patent No. 4409160
[Patent document 3] Japanese Patent No. 4494077
[Patent document 4] Japanese Patent No. 4862032
[Patent document 5] Japanese Patent No. 4908736

### [Summary of the invention]

### [Problem to be solved by the invention]

The present invention was made in view of the abovementioned issues. It is an object of the present invention to provide a silicone composition superior in handling property, and capable of being cured without heating; and a cured product having a high hardness and a high refractive index.

### [Means to solve the problem]

After conducting a series of studies to achieve the above objectives, the present invention was completed as follows. That is, it was found that by using a particular UV curable organopolysiloxane component, there could be obtained a UV curable silicone composition capable of being cured without heating; and a cured product thereof having a high hardness and a high refractive index.

Specifically, the present invention is shown below.
[1] A UV curable silicone composition comprising:
   (A) 100 parts by mass of an organopolysiloxane represented by the following general formula (1) 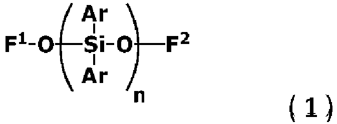
   wherein n represents a number satisfying 1 ≤ n ≤ 100, Ar represents an aromatic group, each of terminal groups F¹ and F² independently represents a group selected from the groups represented by the following formulae (2) and (3), and a ratio of the number of the terminal groups represented by formula (3) to a total number of all the terminal groups represented by F¹ and F² is not lower than 20%, 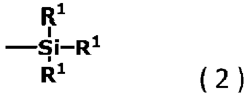 wherein each R¹ independently represents a monovalent hydrocarbon group having 1 to 20 carbon atoms, 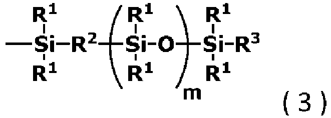 wherein m represents a number satisfying 0 ≤ m ≤ 10, each R¹ independently represents a monovalent hydrocarbon group having 1 to 20 carbon atoms, R² represents an alkylene group, and R³ represents an acryloyl group, a methacryloyl group, an acryloyloxyalkyl group or a methacryloyloxyalkyl group; and (B) 0.1 to 10 parts by mass of a photopolymerization initiator,
[2] and further comprising at least one of
   (C) a monofunctional (meth) acrylate compound not containing a siloxane structure; and
   (D) a multifunctional (meth) acrylate compound not containing a siloxane structure, in a total amount of 1 to 200 parts by mass per 100 parts by mass of the component (A).
[3] A cured product of the UV curable silicone composition as set forth in [1] or [2].
[4] An optical element encapsulation material comprised of the UV curable silicone composition as set forth in [1] or [2].
[5] An optical element encapsulated by the optical element encapsulation material as set forth in [4].

### [Effect of the invention]

Since the UV curable silicone composition of the invention is superior in handling property and does not require a heating step to be cured, energy and time can be saved in the production process. Further, the cured product of the UV curable silicone composition of the invention has a high refractive index and a high hardness.

### [Mode for carrying out the invention]

The present invention is described in greater detail hereunder.

### (A) Organopolysiloxane

A component (A) is an organopolysiloxane represented by the following general formula (1).

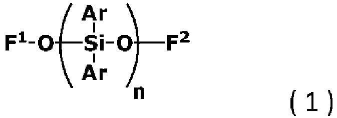

In the formula (1), examples of an aromatic group represented by Ar include an aromatic hydrocarbon group such as a phenyl group, a biphenyl group and a naphthyl group; and an aromatic group containing hetero atoms (O, S, N), such as a furanyl group. Further, the aromatic group represented by Ar may also have substituent groups such as halogen atoms (e.g. chlorine atom, bromine atom and fluorine atom). It is preferred that Ar be an unsubstituted aromatic hydrocarbon group, particularly preferably a phenyl group.

In the formula (1), n satisfies 1 ≤ n ≤ 100, preferably 1 ≤ n ≤ 50, more preferably 1 ≤ n ≤ 20. When n is smaller than 1, the composition will volatilize easily. Further, when n is larger than 100, the composition will exhibit an increased viscosity in a way such that a workability will be impaired.

Each of F¹ and F² independently represents a group selected from the groups represented by the following formulae (2) and (3).

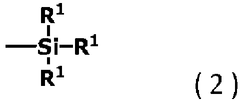

In the formula (2), each R¹ independently represents a monovalent hydrocarbon group having 1 to 20 carbon atoms.

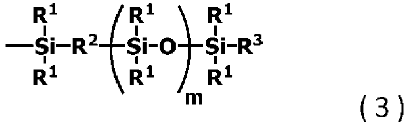

In the formula (3), m satisfies 0 ≤ m ≤ 10; each R¹ independently represents a monovalent hydrocarbon group having 1 to 20 carbon atoms; R² represents an alkylene group; and R³ represents an acryloyl group, a methacryloyl group, an acryloyloxyalkyl group or a methacryloyloxyalkyl group.

Each R¹ in the formulae (2) and (3) independently represents a monovalent hydrocarbon group having 1 to 20 carbon atoms, preferably 1 to 10 carbon atoms. Examples of such monovalent hydrocarbon group include an alkyl group such as a methyl group, an ethyl group, a propyl group, a butyl group, a hexyl group and a dodecyl group; an alkenyl group such as a vinyl group, an allyl group, a 1-butenyl group and a 1-hexenyl group; an aryl group such as a phenyl group; an aralkyl group such as a 2-phenylethyl group and a 2-phenylpropyl group; and halogen-substituted monovalent hydrocarbon groups such as a fluoromethyl group, a bromoethyl group, a chloromethyl group and a 3,3,3-trifluoropropyl group, the halogen-substituted monovalent hydrocarbon groups being obtained by substituting a part of or all the hydrogen atoms in the above hydrocarbon groups with halogen atoms such as chlorine atoms, fluorine atoms and bromine atoms. Among the above groups, it is preferred that not less than 90% of R¹ be a methyl group or a phenyl group in terms of an ease of synthesis and cost. Further, if employing an alkenyl group, it is preferred that such alkenyl group be a vinyl group in terms of the ease of synthesis and cost. The alkenyl group may be present on either the terminal end(s) or midway portion of the molecular chain of the organopolysiloxane. However, it is preferred that such alkenyl group be present only on the terminal end(s) in terms of flexibility.

R² in the formula (3) represents an alkylene group. Examples of such alkylene group include an ethylene group and a trimethylene group, among which an ethylene group is preferred in terms of the ease of synthesis and cost.

R3 in the formula (3) represents an acryloyl group, a methacryloyl group, an acryloyloxyalkyl group or a methacryloyloxyalkyl group. Specific examples of these groups include a 4-acryloyloxybutyl group, a 3-acryloyloxypropyl group, a 4-methacryloyloxybutyl group and a 3-methacryloyloxypropyl group, among which a 4-methacryloyloxybutyl group and a 3-methacryloyloxypropyl group are preferred in terms of the ease of synthesis.

Further, m satisfies 0 ≤ m ≤ 10, preferably 1 ≤ m ≤ 8, more preferably 1 ≤ m ≤ 5. When m is larger than 10, a refractive index will decrease.

The following compounds are examples of the organopolysiloxane represented by the above formula (1).

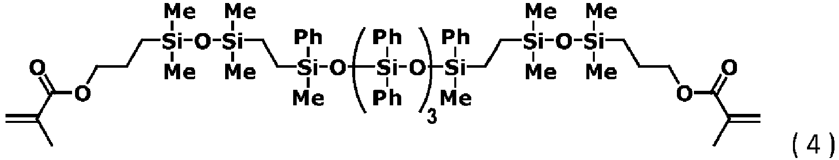

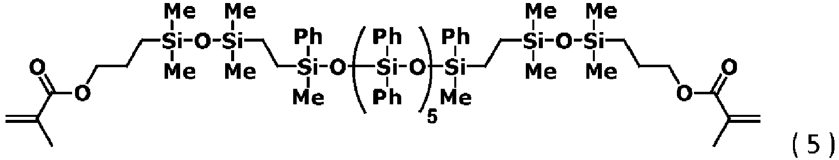

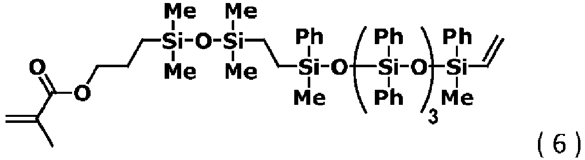

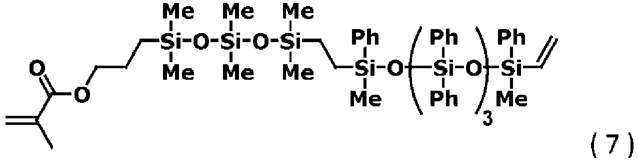

The component (A) may also be a mixture of these compounds. However, a ratio of the number of the terminal groups represented by the formula (3) and having UV reactive groups to the total number of all the terminal groups represented by F¹ and F² in the organopolysiloxane represented by the formula (1), is not lower than 20%, preferably not lower than 30%. When such ratio is lower than 20%, an insufficient UV curability will be exhibited. Here, a ratio of the UV curable terminal groups can be determined by ²⁹Si-NMR.

The organopolysiloxane represented by the general formula (1) can, for example, be synthesized by the following method.

That is, the organopolysiloxane can be obtained by a hydrosilylation reaction between an organopolysiloxane (8) and an organopolysiloxane (9) under the presence of a platinum catalyst. By controlling the molar number of the organopolysiloxane (9) to 0.4 to 2 mol per 1 mol of the organopolysiloxane (8), there can be regulated the ratio of the number of the terminal groups represented by the formula (3) and having UV reactive groups to the total number of all the terminal groups represented by F¹ and F².

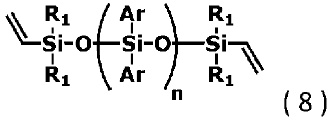

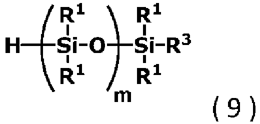

In the formulae (8) and (9), each R¹ independently represents a monovalent hydrocarbon group having 1 to 20 carbon atoms; R³ represents an acryloyl group, a methacryloyl group, an acryloyloxyalkyl group or a methacryloyloxyalkyl group; Ar represents an aromatic group; n represents a number satisfying 1 ≤ n ≤ 100; and m represents a number satisfying 1 ≤ m ≤ 10.

### (B) Photopolymerization initiator

Examples of a photopolymerization initiator include 2,2-diethoxyacetophenone; 2,2-dimethoxy-1,2-diphenylethane-1-one (Irgacure 651 by BASF); 1-hydroxy-cyclohexyl-phenyl-ketone (Irgacure 184 by BASF); 2-hydroxy-2-methyl-1-phenyl-propane-1-one (Irgacure 1173 by BASF); 2-hydroxy-1-{4-[4-(2-hydroxy-2-methyl-propionyl)-benzyl]-phenyl}-2-methyl-propane-1-one (Irgacure 127 by BASF); phenylglyoxylic acid methyl ester (Irgacure MBF by BASF); 2-methyl-1-[4-(methylthio) phenyl]-2-morpholinopropane-1-one (Irgacure 907 by BASF); 2-benzyl-2-dimethylamino-1-(4-morpholinophenyl)-1-butanone (Irgacure 369 by BASF); bis (2,4,6-trimethylbenzoyl)-phenylphosphine oxide (Irgacure 819 by BASF); 2,4,6-trimethylbenzoyl-diphenyl-phosphine oxide (Irgacure TPO by BASF); and mixtures of these compounds.

Among the above examples of the component (B), preferred are 2,2-diethoxyacetophenone; 2-hydroxy-2-methyl-1-phenyl-propane-1-one (Irgacure 1173 by BASF); bis (2,4,6-trimethylbenzoyl)-phenylphosphine oxide (Irgacure 819 by BASF); and 2,4,6-trimethylbenzoyl-diphenyl-phosphine oxide (Irgacure TPO by BASF), in terms of a compatibility with the component (A).

The photopolymerization initiator is added in an amount of 0.1 to 10 parts by mass per 100 parts by mass of the component (A). When such photopolymerization initiator is added in an amount of smaller than 0.1 parts by mass, an insufficient curability will be exhibited. Further, when such photopolymerization initiator is added in an amount of larger than 10 parts by mass, a curability of deep portion will be impaired.

Other than the above essential components, the following components are also added to the composition of the invention.

### (C) Monofunctional (meth) acrylate compound not containing siloxane structure

Examples of a monofunctional (meth) acrylate compound (C) not containing a siloxane structure, include isoamylacrylate, lauryl acrylate, stearyl acrylate, ethoxy-diethylene glycol acrylate, methoxy-triethyleneglycol acrylate, 2-ethylhexyl-diglycol acrylate, phenoxyethyl acrylate, phenoxydiethylene glycol acrylate, tetrahydrofurfuryl acrylate, isobornyl acrylate and mixtures of these compounds. Here, isobornyl acrylate is particularly preferred.

### (D) Multifunctional (meth) acrylate compound containing no siloxane structure

Examples of a multifunctional (meth) acrylate compound (D) not containing a siloxane structure, include triethylene glycol diacrylate, polytetramethylene glycol diacrylate, neopentyl glycol diacrylate, 1,6-hexanediol diacrylate, dimethylol-tricyclodecane diacrylate, trimethylolpropane triacrylate, pentaerythritol tetraacrylate and mixtures of these compounds. Here, dimethylol-tricyclodecane diacrylate is preferred.

The (meth) acrylate compounds as the components (C) and (D) are contained in an amount of 1 to 200 parts by mass, more preferably 1 to 100 parts by mass, per 100 parts by mass of the component (A). When they are added in an amount of larger than 200 parts by mass per 100 parts by mass of the component (A), a cured product may exhibit a hardness higher than it should be, and desired rubber physical properties may not be achieved.

### Preparation method of silicone composition

A UV curable silicone composition of the invention is obtained by, for example, stirring and mixing the above components (A) and (B), (C), (D) and if necessary other components. Although there are no particular restrictions on devices used to perform stirring or the like, a kneader, a triple roll mill, a ball mill and a planetary mixer may, for example, be used. Further, these devices may be appropriately used in combination with one another.

It is preferred that a viscosity of the UV curable silicone composition of the invention be not higher than 5,000 mPa·s, more preferably not higher than 3,000 mPa·s, in terms of handling property. Here, the viscosity is a value measured by a rotary viscometer at 25°C.

On the premise that the effects of the invention will not be impaired, there may also be added to the composition of the invention additives such as a silane coupling agent, a polymerization inhibitor, an antioxidant, an ultraviolet absorber as a light resistance stabilizer, and a light stabilizer. Further, the composition of the invention may also be appropriately mixed with an other resin composition(s) before use.

The UV curable silicone composition of the invention can be quickly cured when irradiated by an ultraviolet light. Examples of a light source of the ultraviolet light used to irradiate the UV curable silicone composition of the invention, include a UV LED lamp, a high-pressure mercury lamp, a super high-pressure mercury lamp, a metal halide lamp, a carbon-arc lamp and a xenon lamp. It is preferred that an irradiation level (accumulated amount of light) of the ultraviolet light be 1 to 5,000 mJ/cm², more preferably 10 to 2,000 mJ/cm², with respect to, for example, a sheet formed of the composition of the invention and having a thickness of about 2.0 mm. That is, when employing an ultraviolet light with an illuminance of 100 mW/cm², an ultraviolet irradiation of a time length of about 0.01 to 50 sec will suffice.

That is, as compared to a conventional composition that employs a hydrosilylation reaction and requires at least about several hours of heating to be cured, the UV curable silicone composition of the invention can be cured in a significantly short period of time.

Further, in order for the cured product of the UV curable silicone composition of the invention to exhibit superior rubber physical properties, it is preferred that such cured product exhibit a hardness of not lower than 40 (Type A), more preferably not lower than 50 (Type A). Further, it is preferred that this cured product exhibit a tensile strength of not lower than 1.0 MPa, more preferably not lower than 2.0 MPa. Furthermore, it is preferred that this cured product exhibit an elongation at break of not smaller than 10%, more preferably not smaller than 20%. These values are measured in accordance with JIS-K 6249. The hardness of the cured product can be controlled by adjusting the number of the terminal groups represented by the formula (3) of the component (A).

Moreover, it is preferred that the refractive index of the cured product of the UV curable silicone composition of the invention be not lower than 1.50. In order to achieve a refractive index of not lower than 1.50, it is sufficient that m in the formula (3) of the component (A) be not larger than 10.

### [Working example]

The present invention is described in detail hereunder with reference to preparation, working and comparative examples. However, the present invention is not limited to the following working examples.

In the following examples, the viscosity of a composition is a value measured by a rotary viscometer at 25°C. Hardness, elongation at break and tensile strength were measured in accordance with JIS-K 6249. Curing was performed under the following conditions. That is, a lamp (H (M) 06-L-61 by EYE GRAPHICS Co., Ltd.) was used to perform ultraviolet irradiation at an irradiation level of 2,000 mJ/cm² under a nitrogen atmosphere. Also, the thickness of a sheet was set to be 2.0 mm.

### • Preparation of component (A)

### [Preparation example 1]

Put into a 3L flask were 520.96 g of 1-(3-methacryloyloxypropyl)-1,1,3,3-tetramethyldisiloxane and 905.42 g of an organopolysiloxane (A-0) represented by the following chemical formula (10), followed by heating the same to 100°C, and then adding thereto 0.30 g of a Karstedt catalyst (i.e. a complex of chloroplatinic acid and sym- divinyltetramethyldisiloxane) so as to perform heating at 100°C for another 3 hours. After being cooled to a room temperature, an organopolysiloxane (A-1) was obtained.

According to ²⁹Si-NMR, the ratio of the UV curable terminal groups was 90%, and the viscosity of the organopolysiloxane was 700 mPa·s at 25°C.

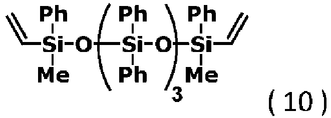

### [Preparation example 2]

Similar steps as those in preparation example 1 were performed, except that 1-(3-methacryloyloxypropyl)-1,1,3,3-tetramethyldisiloxane was now added in an amount of 260.48 g. As a result, an organopolysiloxane (A-2) was obtained.
According to ²⁹Si-NMR, the ratio of the UV curable terminal groups was 50%, and the viscosity of the organopolysiloxane was 900 mPa·s at 25°C.

### [Preparation example 3] (Preparation of component (A) for use in comparative example)

Similar steps as those in preparation example 1 were performed, except that 1-(3-methacryloyloxypropyl)-1,1,3,3-tetramethyldisiloxane was now added in an amount of 52.01 g. As a result, an organopolysiloxane (A-3) was obtained.

According to ²⁹Si-NMR, the ratio of the UV curable terminal groups was 10%, and the viscosity of the organopolysiloxane was 1800 mPa·s at 25°C.

### • Other organopolysiloxanes (Components (A) for use in comparative examples)

### Organopolysiloxane (A-4):

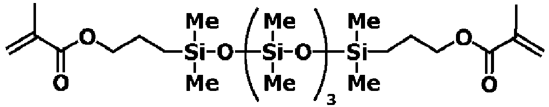

### Organopolysiloxane (A-5):

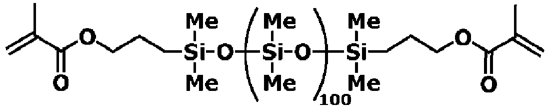

### • Component (B)

(B-1): 2-hydroxy-2-methyl-1-phenyl-propane-1-one (Irgacure 1173 by BASF)
(B-2): 2,4,6-trimethylbenzoyl-diphenyl-phosphine oxide (Irgacure TPO by BASF)

### • Component (C)

Isobornyl acrylate

### • Component (D)

Dimethylol-tricyclodecane diacrylate

### [Working examples 1 to 4; Comparative examples 1 and 2]

### (Working example 1 not according to the invention)

A silicone composition was obtained by uniformly mixing the components shown in Table 1 at the corresponding composition ratios. The viscosity of the composition obtained in each example was measured by a rotary viscometer at 25°C.

Further, such composition was poured into a frame to be formed into the shape of a sheet having a thickness of 2.0 mm, followed by using a lamp (H (M) 06-L-61 by EYE GRAPHICS Co., Ltd.) to cure the same under a nitrogen atmosphere and at a UV irradiation level of 2,000 mJ/cm², thus obtaining a cured sheet. The hardness, tensile strength and elongation at break of the cured sheet obtained were measured in accordance with JIS-K6249, and the refractive index of such cured sheet was measured as well. The results thereof are shown in Table 1.

**Table 1**

| | | Working example | | | | Comparative example | | | |
|---|---|---|---|---|---|---|---|---|---|
| | | 1 | 2 | 3 | 4 | 1 | 2 | 3 | 4 |
| Composition (part by mass) | (A-1) | 100 | 100 | 0 | 0 | 0 | 0 | 0 | 0 |
| | (A-2) | 0 | 0 | 100 | 100 | 0 | 0 | 0 | 0 |
| | (A-0) | 0 | 0 | 0 | 0 | 100 | 0 | 0 | 0 |
| | (A-3) | 0 | 0 | 0 | 0 | 0 | 0 | 100 | 0 |
| | (A-4) | 0 | 0 | 0 | 0 | 0 | 0 | 0 | 100 |
| | (A-5) | 0 | 0 | 0 | 0 | 0 | 100 | 0 | 0 |
| | (B-1) | 4 | 4 | 1.3 | 1.3 | 7 | 1.4 | 4 | 4 |
| | (B-2) | 0 | 0 | 1.3 | 1.3 | 0 | 1.4 | 0 | 0 |
| | (C) | 0 | 20 | 33 | 25 | 70 | 40 | 0 | 0 |
| | (D) | 0 | 5 | 0 | 0 | 0 | 0 | 0 | 0 |
| Physical property | Viscosity of composition (mPa·s) | 550 | 190 | 160 | 200 | 64 | 90 | 1800 | 10 |
| | Hardness (TypeA) | 80 | 91 | 70 | 60 | Uncured | 35 | Uncured | 60 |
| | Tensile strength (MPa) | 2.0 | 5.9 | 5.5 | 3.1 | Uncured | 1.0 | Uncured | 0.2 |
| | Elongation at break (%) | 20 | 23 | 50 | 50 | Uncured | 160 | Uncured | 5 |
| | Refraction index | 1.54 | 1.53 | 1.54 | 1.54 | 1.52 | 1.41 | 1.53 | 1.41 |

The cured products of the UV curable silicone compositions of the invention exhibited high hardnesses and high refractive indexes. In contrast, UV curing did not take place in comparative example 1 where the UV curable terminal group-absent organopolysiloxane (A-0) was used instead of the component (A) of the present invention, and in comparative example 3 where the organopolysiloxane (A-3) having the UV curable terminal groups at a ratio of less than 20% was used instead of the component (A) of the present invention. Further, a low hardness and refractive index were exhibited by a cured product prepared in comparative example 2 employing the organopolysiloxane (A-5) having methyl groups instead of aromatic groups as is the case in formula (1). Furthermore, a low tensile strength and refractive index were exhibited by a cured product prepared in comparative example 4 employing the organopolysiloxane (A-4).

### [Industrial applicability]

The UV curable silicone composition of the invention does not require a heating step to be cured, thereby contributing to energy and time saving in the production process thereof Further, the cured product of the UV curable silicone composition of the invention has a high hardness and a high refractive index, and is thus useful in the field of optics, particularly in the field of lens and optical element encapsulation.

## Claims

1. A UV curable silicone composition comprising:
(A) 100 parts by mass of an organopolysiloxane represented by the following general formula (1) 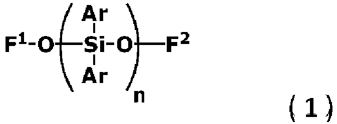 wherein n represents a number satisfying 1 ≤ n ≤ 100, Ar represents an aromatic group, each of terminal groups F¹ and F² independently represents a group selected from the groups represented by the following formulae (2) and (3), and a ratio of the number of the terminal groups represented by formula (3) to a total number of all the terminal groups represented by F¹ and F² is not lower than 20%, 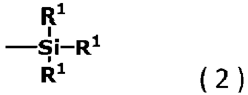 wherein each R¹ independently represents a monovalent hydrocarbon group having 1 to 20 carbon atoms, 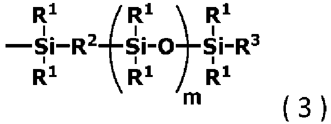 wherein m represents a number satisfying 0 ≤ m ≤ 10, each R¹ independently represents a monovalent hydrocarbon group having 1 to 20 carbon atoms, R² represents an alkylene group, and R³ represents an acryloyl group, a methacryloyl group, an acryloyloxyalkyl group or a methacryloyloxyalkyl group; and
(B) 0.1 to 10 parts by mass of a photopolymerization initiator; and further comprising at least one of
(C) a monofunctional (meth) acrylate compound not containing a siloxane structure; and
(D) a multifunctional (meth) acrylate compound not containing a siloxane structure, in a total amount of 1 to 200 parts by mass per 100 parts by mass of the component (A).

2. A cured product of the UV curable silicone composition as set forth in claim 1.

3. An optical element encapsulation material comprised of the UV curable silicone composition as set forth in claim 1.

4. An optical element encapsulated by the optical element encapsulation material as set forth in claim 3.

## Patentansprüche

1. UV-härtbare Silikonzusammensetzung umfassend:
(A) 100 Massenteile eines Organopolysiloxans der folgenden allgemeinen Formel (1) 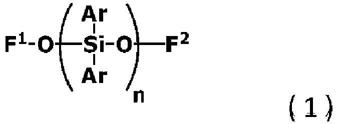 wobei n für eine Anzahl steht, die 1 ≤ n ≤ 100 steht, Ar für eine aromatische Gruppe steht, jede der terminalen Gruppen F¹ und F² unabhängig für eine Gruppe steht, die aus den Gruppen der folgenden Formeln (2) und (3) ausgewählt sind, und ein Verhältnis der Anzahl der terminalen Gruppen der Formel (3) zu einer Gesamtanzahl von allen der terminalen Gruppen der F¹ und F² nicht weniger als 20 % beträgt, 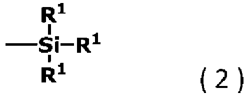 wobei jeder R¹ unabhängig für eine einwertige Kohlenwasserstoffgruppe mit 1 bis 20 Kohlenstoffatomen steht, 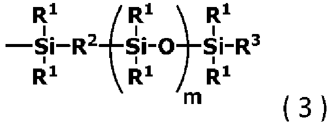 wobei m für eine Anzahl steht, die 0 ≤ m ≤ 10 erfüllt, jeder R¹ unabhängig für eine einwertige Kohlenwasserstoffgruppe mit 1 bis 20 Kohlenstoffatomen steht, R² für eine Alkylengruppe steht, und R³ für eine Acryloylgruppe, eine Methacryloylgruppe, eine Acryloyloxyalkylgruppe oder eine Methacryloyloxyalkylgruppe steht; und
(B) 0,1 bis 10 Massenteile eines Photopolymerisationsinitiators; und ferner umfassend mindestens eine aus:
(C) einer monofunktionellen (Meth)acrylatverbindung, die keine Siloxanstruktur beinhaltet; und
(D) einer multifunktionellen (Meth)acrylatverbindung, die keine Siloxanstruktur beinhaltet, in einer Gesamtmenge von 1 bis 200 Massenteilen je 100 Massenteile der Komponente (A).

2. Gehärtetes Produkt der UV-härtbaren Silikonzusammensetzung nach Anspruch 1.

3. Verkapselungsmaterial für ein optisches Element, das aus der UV-härtbaren Silikonzusammensetzung nach Anspruch 1 gebildet ist.

4. Optisches Element, das durch das Verkapselungsmaterial für ein optisches Element nach Anspruch 3 verkapselt ist.

## Revendications

1. Composition de silicone durcissable aux UV, comprenant :
(A) 100 parties en masse d'un organopolysiloxane représenté par la formule générale suivante (1) 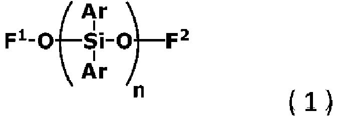 dans laquelle n représente un nombre satisfaisant 1 ≤ n ≤ 100, Ar représente un groupe aromatique, chacun des groupes terminaux F¹ et F² représente indépendamment un groupe choisi parmi les groupes représentés par les formules suivantes (2) et (3), et un rapport du nombre des groupes terminaux représentés par la formule (3) à un nombre total de tous les groupes terminaux représentés par F¹ et F² n'est pas inférieur à 20%, 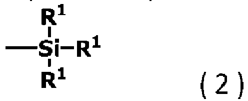 dans laquelle chaque R¹ représente indépendamment un groupe hydrocarboné monovalent avant 1 à 20 atomes de carbone, 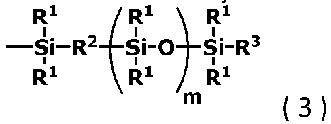 dans laquelle m représente un nombre satisfaisant 0 ≤ m ≤ 10, chaque R¹ représente indépendamment un groupe hydrocarboné monovalent ayant 1 à 20 atomes de carbone, R² représente un groupe alkylène, et R³ représente un groupe acryloyle, un groupe méthacryloyle, un groupe acryloyloxyalkyle ou un groupe méthacryloyloxyalkyle ; et
(B) 0,1 et 10 parties en masse d'un initiateur de photopolymérisation ; et comprenant en outre au moins l'un parmi
(C) un composé (méth) acrylate monofonctionnel ne contenant pas de structure siloxane ; et
(D) un composé (méth) acrylate multifonctionnel ne contenant pas de structure siloxane, en une quantité totale de 1 à 200 parties en masse pour 100 parties en masse du composant (A).

2. Produit durci de la composition de silicone durcissable par les UV selon la revendication 1.

3. Matériau d'encapsulation d'élément optique constitué de la composition de silicone durcissable aux UV selon la revendication 1.

4. Elément optique encapsulé par le matériau d'encapsulation d'élément optique selon la revendication 3.
